# EUROPEAN PATENT SPECIFICATION

(11) **EP 0 209 359 B1**
(45) Date of publication and mention of the grant of the patent: **27.10.1993**
(21) Application number: 86305439.1
(22) Date of filing: 15.07.1986
(51) Int. Cl.: B41M 5/26

(54) **Dye receiving sheet for heat-transfer recording**
Farbaufnahmeblatt für Übertragungsaufzeichnung durch Wärme
Couche réceptrice pour le colorant, pour l'enregistrement par transfert thermique

(30) Priority: 15.07.1985 JP 155433/85; 17.07.1985 JP 157201/85; 24.07.1985 JP 163417/85
(43) Date of publication of application: 21.01.1987
(73) Proprietor: MATSUSHITA ELECTRIC INDUSTRIAL CO., LTD., Kadoma-shi, Osaka-fu, 571 (JP)
(72) Inventor: Yubakami, Keiichi, Suita-shi Osaka (JP); Matsuda, Hiromu, Katano-shi Osaka (JP); Imai, Akihiro, Ikoma-shi Nara-ken (JP); Taguchi, Nobuyoshi, Ikoma-shi Nara-ken (JP)
(74) Representative: Myerscough, Philip Boyd

(56) References cited:
- EP-A- 0 111 011
- FR-A- 2 524 846
- US-A- 4 273 602
- PATENT ABSTRACTS OF JAPAN, vol. 7, no. 287 (M-264)[1432], 21st December 1983; JP-A-58 162 374
- PATENT ABSTRACTS OF JAPAN, vol. 8, no. 69 (M-286)[1506], 31st March 1984; JP-A-58 215 398
- PATENT ABSTRACTS OF JAPAN, vol. 9, no. 98 (M-375)[1821], 27th April 1985; JP-A-59 222 389
- PATENT ABSTRACTS OF JAPAN, vol. 8, no. 262 (M-341)[1699], 30th November 1984; JP-A-59 133 098

## Description

This invention relates to a method of heat-transfer recording in which a dye transfer sheet is heated in an imagewise pattern by means of a heat source such as a thermal head or laser beam and a dye contained in the dye transfer sheet is sublimated or vaporized to record an intended image on the dye-receiving layer of a dye-receiving sheet.

Known dye-receiving sheets can be broadly classified into the following three groups with respect to the dyeing layer thereof.
(1) EP-A-111011 corresponding to JP-A-58-212994) discloses a dye-receiving sheet for heat transfer recording used in combination with a dye transfer sheet. The dye-receiving layer is made of a crosslinked product of a composition which comprises from 20 to 98 parts by weight of a thermoplastic resin having good dyeing affinity and, correspondingly, from 80 to 2 parts by weight of a compound having, in one molecule thereof, at least two radically polymerizable unsaturated bonds such as acrylates and epoxy acrylates.
(2) A dye-receiving layer consisting of a thermoplastic polyester resin and a crosslinked polymer resin (Japanese Laid-open Patent Application No. 58-215398).
(3) JP-A-58-162374 discloses a method involving the transfer of a dye to a polyvinyl chloride molding in which a resin film curable by ultraviolet radiation is formed on the polyvinyl chloride molding. A sublimable dye is superposed on the cured resin film and pressed while heating. This leads to the formation of a UV-cured resin film on the polyvinyl chloride molding.

These dye-receiving sheets have the following drawbacks.
(a) Because the compound having radically polymerizable unsaturated bonds in (1) does not have good dyeing properties, the recording density is lowered owing to the incorporation of the compound in the dye-receiving layer.
(b) The dye-receiving layer proposed in (2) does not have satisfactory heat resistance. If thermal transfer recording or printing is effected such that a dye transfer sheet and a dye image acceptor sheet are run at different speeds for recording, the resin carrying the dye on the dye transfer sheet thermally sticks to the dye acceptor sheet. For instance, when the dye transfer sheet is fed at a rate of 1/n, in which n >1, relative to the the running speed of the image acceptor sheet, thermal sticking takes place, so that the dye transfer sheet and the dye acceptor sheet cannot be run at predetermined speeds. The above running mode may be hereinafter referred to as "n-fold variable mode".
(c) The technique proposed in (3) is a so-called sublimation printing technique in which printing is effected using sublimable dyes. This technique does not ensure satisfactory dyeing affinity when high temperature recording is effected within a short time of the order of milliseconds.
(d) In (3), a UV-cured film is formed, but it is inevitable that a UV-curing resin or UV-curing initiator remains unreacted and thus, reacts with dye. Accordingly, the accepted dye inconveniently undergoes discoloration and decoloration.

The present invention provides a method of heat transfer recording which method comprises the use of a dye-receiving sheet in combination with a dye transfer sheet in either a non-variable mode in which said sheets are run at the same speed or in a variable mode in which said sheets are run at different speeds, said dye-receiving sheet comprising, on a sheet substrate, a layer comprising a cured product of a polyester urethane(meth)acrylate which has two(meth)acrylic groups and up to 30 parts by weight of a saturated polyester resin per 100 parts by weight of said polyester urethane(meth)acrylate.
Fig. 1 is a schematic sectional view of a dye-receiving sheet according one embodiment of the invention; and
Fig. 2 is a schematic sectional view of a dye-receiving sheet according to another embodiment of the invention.

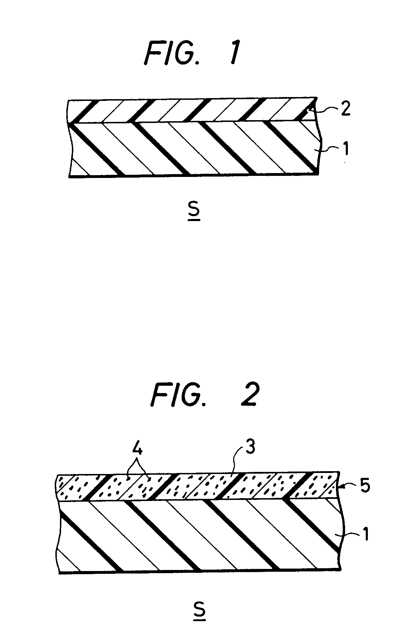

Reference is now made to the accompanying drawings and particularly, to Fig. 1. In the figure, there is shown a dye-receiving sheet S which includes a substrate 1 on which a dye-receiving layer 2 comprising a cured product of polyester urethane (meth)acrylate as described above. The substrate 1 may be sheets or films of, for example, woodfree paper, coated paper, art paper, synthetic paper, polymers such as polypropylene, polyethylene terephthalate or triacetyl cellulose. The dye-receiving layer 2 preferably consists of the cured product of the (meth)acrylate. Polyester urethane(meth)acrylates are chosen because of their high affinity for sublimable dyes. Of various polyester urethane(meth)acrylates, (meth)acrylate compounds of the following formula (A) are more preferred 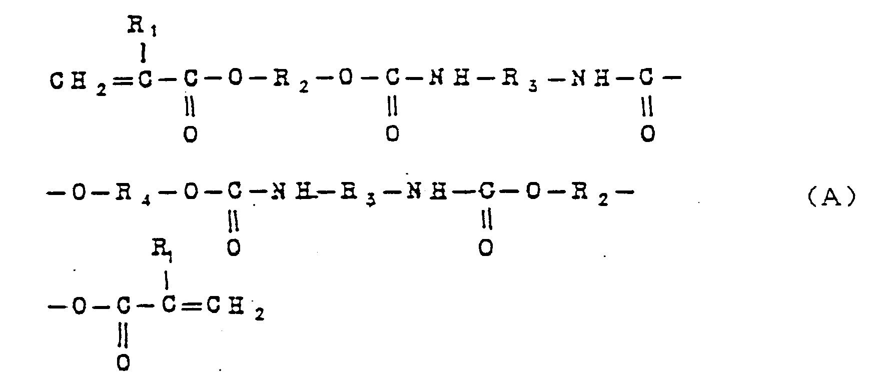
in which each R₁ represents H or CH₃, each R₂ represents a dihydric alcohol residue, each R₃ represents an organic diisocyanate residue, and R₄ represents a polyester residue having hydroxyl groups at opposite ends of the molecule. The reason why the compounds of the formula (A) are more preferred is that the -O-R₄-O- bond is capable of imparting high dyeing properties and high flexibility to the resulting cured product.

The dihydric alcohol residues represented by R₂ in the formula (A) are those residues derived from dihydric alcohols. Examples of the dihydric alcohols include ethylene glycol, 1,2-propanediol, 2,2-dimethyl-1,3-propanediol, 1,3-butanediol, 1,4-butanediol, 1,5-pentanediol, 1,6-hexanediol, 1,9-nonanediol and 1,4-cyclohexanediol. Preferably, dihydric alcohols having 6 or less carbon atoms are used because a higher heat resistance is ensured.

The organic diisocyanate residues represented by R₃ in the formula (A) are residues derived from organic diisocyanates. Examples of the organic diisocyanates include tolylenediisocyanate, naphthylenediisocyanate, nitrodiphenyldiisocyanate, diphenylsulfonediisocyanate, diphenylmethanediisocyanate, tolylenediisocyanate dimer, isophoronediisocyanate, xylylenediisocyanate, hexamethylenediisocyanate and methylenebis(4-cyclohexylisocyanate). Of these, tolylenediisocyante is preferred because of its good characteristics, and isophoronediisocyante, xylylenediisocyante, hexamethylenediioscyanate and methylenebis(4-cyclohexylisocyanate) are also preferred because little or no yellowing takes place when these residues are contained.

The polyester residues represented by R₄, which have hydroxyl groups at ends of the molecule, are residues derived from known compounds prepared from dibasic carboxylic acids and dihydric alcohols. Examples of the carboxylic acids include succinic acid, adipic acid, pimelic acid, phthalic acid, isophthalic acid, terephthalic acid, maleic acid, fumaric acid and itaconic acid. Examples of the dihydric alcohols include those indicated before.

The polyester residue, R₄, in the soft segment, -O-R₄-O-, of the general formula (A) should preferably have a number-average molecular weight not larger than 3000. This is because, within the above range, the cured product is not so flexible that there occurs no fogging of an image owing to the bleeding of a sublimable dye in the image while suppressing a lowering of heat resistance, thereby obtaining a good image-receiving sheet.

When a polyester residue R₄ in the formula (A) is obtained from a dihydric alcohol having from 2 to 6 carbon atoms and at least one dicarboxylic acid selected from adipic acid or terephthalic acid, is used, the resulting layer 2 advantageously has a higher dye affinity and a higher heat resistance. Thus, these polyester residues are preferred. Preferably, the dihydric alcohol is ethylene glycol and/or propylene glycol. Most preferably, the polyester residues obtained from at least one dihydric alcohol selected from ethylene glycol and/or propylene glycol and at least one dibasic carboxylic acid selected from adipic acid and terephthalic acid are used because the resulting layer 2 has significantly higher dyeing affinity and heat resistance characteristics.

Another type of more preferable polyester urethane(meth)acrylate has the following general formula (B), by which higher reactivity is ensured with the resulting layer 2 having high dyeing affinity and heat resistance characteristics. 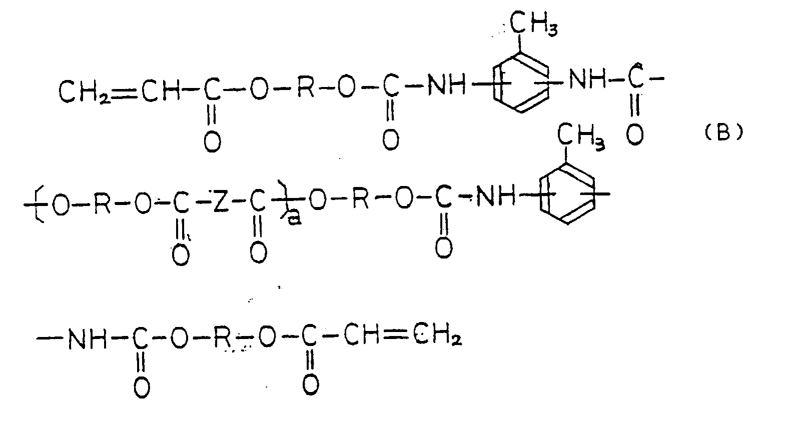
in which a is a natural number, each R represents an alkylene group and Z represents a phenylene group, a substituted phenylene group or an alkylene group. The alkylene group represented by R and Z includes, for example, groups of ethylene, propylene, ethylethylene, pentamethylene or hexamethylene. Examples of the substituted phenylene group include tolylene, xylylene, ethylphenylene and cumenylene.

Fig. 2 shows a schematic sectional view of a dye-receiving sheet according to another embodiment of the invention. In the figure, there is shown a dye-receiving sheet S which includes a substrate 1 and a dye-receiving layer 5 which comprises a cured product of a mixture of polyester urethane(meth)acrylate 3 and a saturated polyester resin 4.

The (meth)acrylate is one which is defined with reference to the first embodiment. The saturated polyester resin 4 may be any known compounds obtained from dibasic carboxylic acids and dihydric alcohols. Examples of these dibasic carboxylic acids and dihydric alcohols may be those indicated before.

The content of the saturated polyester resin in the dye-receiving layer 5 is not larger than 30 parts by weight per 100 parts by weight of the acrylate. Outside this range, the heat resistance of the dye-receiving layer 5 is impeded, so that the resultant sheet is not adapted for the variable mode although it may be applicable to the non-variable mode.

For the formation of the dye-receiving layer 2 or 5, a solution of polyester urethane(meth)acrylate and a polymerization initiator is applied onto the substrate 1 for the layer 2, or a solution of the (meth)acrylate, a polymerization initiator and a saturated polyester is applied onto the substrate 1 for the layer 5 by known techniques using, for example, a bar coater, a gravure coater, a knife coater or a reverse roll coater. The layer 2 or 5 should preferably be coated in an amount of not less than 1 g/m². If the amount is less than 1 g /m², the recording density lowers.

The polymerization initiators are usually used for polymerization of the (meth)acrylate and are properly selected depending on the manner of polymerization. The polymerization may be effected using UV rays, electron beams, heat energy or the like as is known in the art. In an industrial sense, UV rays or heat energy is generally used.

The polymerization initiators used for polymerization with UV rays may be any compounds ordinarily used for this purpose and may be used in combination with sensitizers such as, for example, benzophenone. The polymerization initiators used on polymerization by application of heat may be peroxides such as, for example, methyl ethyl ketone peroxide.

If the acrylate in the layer 2 or 5 is cured by application of UV rays alone, the resulting layer may be, in some cases, disadvantageous in that the (meth)acrylate is apt to partially remain unreacted and the unreacted (meth)acrylate reacts, along with a UV sensitizer, with a sublimable dye, causing the deposited dye to decolor or discolor. To avoid this, curing by heat is preferred because the (meth)acrylate used is substantially polymerized and cured. The resulting dye-receiving sheet ensures a long-term stability of the dye deposited on the dye-receiving layer, thus preventing the decoloration or discoloration.

Especially, when UV sensitizers used are not reactive with sublimable dyes, curing by UV irradiation and heat in combination are industrially useful. The manner of curing is not critical in the practice of the invention and is particularly described in examples.

The layer 2 or 5 may further comprise other types of reactive monomers, reactive oligomers, curing promotors and the like. Preferably, the layer 2 or 5 further comprises at least one reactive monomer or oligomer. Examples of the reactive monomers include butoxyethyl acrylate, lauryl acrylate, stearyl acrylate, triethylene glycol diacrylate, neopentylglycol diacrylate, methacrylic acid, 2-hydroxyethyl methacrylate, 2-hydroxypropyl methacrylate, 2-hydroxyethyl acrylate, dimethylaminoethyl methacrylate, diethylamino methacrylate, ethylene glycol dimethacrylate, diethylene glycol methacrylate, triethylene glycol dimethacrylate, trimethylolpropane trimethacrylate, tetrahydrofurfuryl acrylate, 1,6-hexanediol diacrylate, carbitol ethyl acrylate, triglycol methyl acrylate, 2-hydroxy-3-phenyloxypropyl acrylate, trimethylolpropane triacrylate, 2-hydroxyethylacryloyl phosphate and dipentaerythritol pentacrylate. Examples of the reactive oligomers include polyester acrylates and polyol acrylates. These monomers and oligomers may be added up to 50 wt% of the main acrylate. The curing promotor may include metal chlorides such as cobalt naphtenate and amine compounds.

In addition, the dye-receiving layer 2 or 5 may further comprise particles of, for example, aluminium oxide, titanium oxide, silicon dioxide, calcium carbonate, guanamine resins, polyamide resins and polypropylene resin. Lubricants and/or surface active agents may be further added.

The present invention is more particularly described by way of examples.

### Comparative Example 1

100 parts by weight of an epoxy acrylate (Ripoxy SP -1509, available from Showa Koubunshi Co., Ltd.), 5 parts by weight of 1-(4-isopropylphenyl)-2-hydroxy-2-methylpropan-1-on (Darocur 1116, available from E. Merck, Darmstadt Germany) and 500 parts by weight of ethyl acetate were mixed to obtain a coating paint. The paint was coated onto a commercially available art paper by means of a bar coater and dried, followed by irradiation with a high pressure mercury lamp of 1KW for 1 minute to obtain dye-receiving sheet 1'. The coating amount was 2 g/m².

### Comparative Example 2

100 parts by weight of an oligoester acrylate (Aronix M-8030, from Toa Synthetic Chem. Ind. Co., Ltd.), 3 parts by weight of Darocur 1116 and 500 parts by weight of toluene were mixed to obtain a coating paint. The paint was coated onto a polypropylene-base synthetic paper (Yupo FPG150, available from Ohji Yuka Synthetic Paper Co., Ltd.) by means of a bar coater, followed by drying and irradiation with a high pressure mercury lamp of 1 KW for 1 minute to obtain dye-receiving sheet 2'. The amount was 15 g/m².

### Example 1

32 parts by weight of a polyester urethane acrylate of the following formula having an average molecular weight of 1600, 3.8 parts by weight of dipentaerythritol hexaacrylate, 3.2 parts by weight of benzoyloxyethyl acrylate, 0.2 parts by weight of a silicone additive (kp-301, available from Shinetsu Chem. Ind. Co., Ltd.) and 100 parts by weight of ethyl acetate were mixed to obtain a coating paint. The paint was coated onto a polyester-base synthetic paper (Peach Coat SE80, available from Nisshin Boseki Co., Ltd.) by means of a bar coater. The paint was dried and irradiated with a high pressure mercury lamp of 1 KW for 1 minute to obtain dye-receiving sheet 1. The coating amount was 8 g/m².

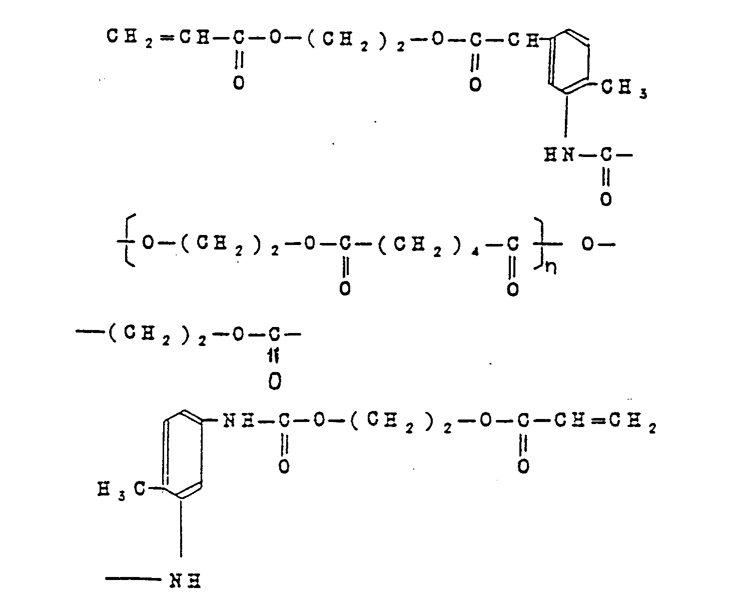

### Example 2

21 parts by weight of a polyester urethane acrylate of the following formula having an average molecular weight of 3000, 1.5 parts by weight of 1-hydroxycyclohexyl phenyl ketone and 100 parts by weight of ethyl acetate were mixed to obtain a coating paint. The paint was coated onto the synthetic paper of Yupo FPG150 by means of a bar coater, followed by drying and irradiation with a high pressure mercury lamp of 1 KW to obtain dye-receiving sheet 2. The coating amount was 5 g/m².

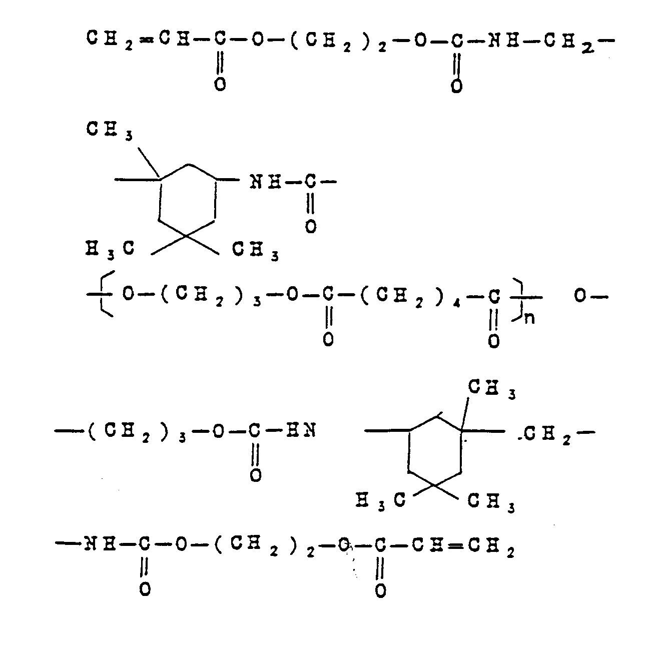

### Example 3

100 parts by weight of a polyester urethane acrylate composed mainly of a compound of the following formula, 5 parts by weight of Darocur 1116 and 140 parts by weight of methyl ethyl ketone were mixed to obtain a coating paint. The paint was coated onto the synthetic paper of Peach Coat SE80 by means of a bar coater, followed by drying and irradiation with a high pressure mercury lamp of 1 KW for 2 minutes to obtain dye-receiving sheet 3. The coating amount was 2.5 g/m².

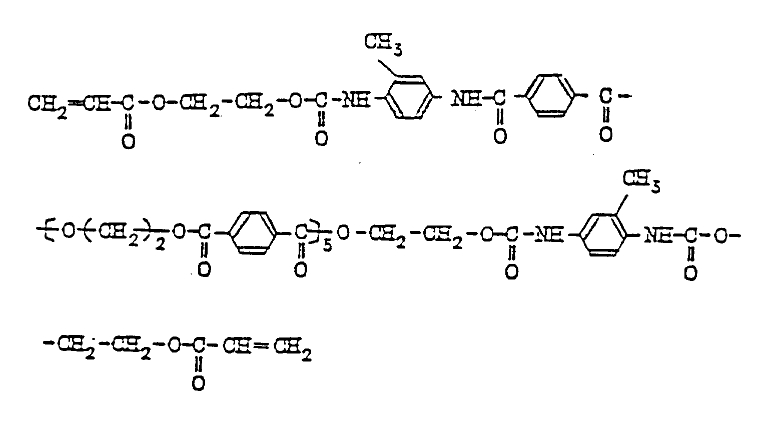

### Example 4

250 parts by weight of a polyester urethane acrylate solution, MCF-3M-2, available from Dainippon Ink Chem. Ind. Co., Ltd. and having a solid content of 40 wt% in a mixed solvent of methyl ethyl ketone and ethyl acetate at a ratio of 1:3, 30 parts by weight of saturated polyester Vylon #200 (available from Nisshin Boseki Co., Ltd.) and 5 parts by weight of a UV curing initiator, MCF-cat, (Dainippon Ink Chem. Ind. Co., Ltd.) were mixed to obtain a coating paint. The paint was applied onto the synthetic paper of Yupo FPG150 by means of a bar coater, followed by drying and irradiation with a high pressure mercury lamp of 1 KW for 2 minutes to obtain dye-receiving sheet 4. The coating amount of 4 g/m².

### Comparative Example 3

The coating paint of Example 4 was used but Vylon #200 was increased from 30 parts by weight to 50 parts by weight, and coated in the same manner as in Example 1, thereby obtaining dye-receiving sheet 3'. The coating amount was 4 g/m².

The dye-receiving sheets 1 through 4 and 1' through 3' were subjected to measurement of a color density using a dye transfer sheet under the following conditions.

The dye transfer sheet was made by a procedure in which a dispersion of 4 parts by weight of a sublimable dye having the following chemical formula, 6 parts by weight of polycarbonate, 3 parts by weight of titanium oxide and 100 parts by weight of methylene chloride was coated onto a 9 micrometer thick polyimide film by the use of a bar coater and dried to obtain a dye transfer sheet.

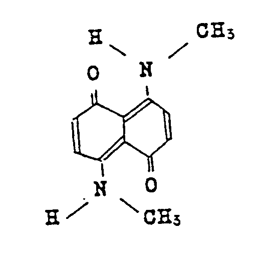

The recording conditions used were as follows.
Main and sub scanning densities: 4 dots/mm
Recording power: 0.7 W/dot
Heating time for a head: 8 ms.
(1) Non-variable mode: (running speed of dye-receiving sheet)/(running speed of dye transfer sheet) = 1/1
(2) 6-fold variable mode: (running speed of dye-receiving sheet)/(running speed of dye transfer sheet) = 6/1
The results are shown in the Table below.

**Table**

| Dye-receiving Sheet No. | Initial Density | | Density After 3 Months Non-variable Mode |
|---|---|---|---|
| | Non-variable Mode | 6-fold Variable Mode | |
| 1 | 2.14 | 1.97 | 1.05 |
| 2 | 1.90 | 1.73 | 0.98 |
| 3 | 1.99 | 1.81 | 1.02 |
| 4 | 2.05 | 1.90 | 1.15 |
| 1' | 1.65 | 1.59 | 0.58 |
| 2' | 1.55 | 1.49 | 0.62 |
| 3' | 2.06* | - ** | 1.24 |
| Note: | | | |

| | | | |
|---|---|---|---|
| * indicates sticking between the dye transfer sheet and the dye-receiving sheet. | | | |
| ** indicates considerable sticking, making it impossible to run. | | | |

As will be apparent from the above table, the dye-receiving layers comprising cured products of polyester urethane (meth)acrylates having two (meth)acrylic unsaturated bonds have high affinity for the sublimable dye (sheets 1 through 4).

Upon comparison between Comparative Examples 1' and 2' and Examples 1 and 3, it will be seen that high recording densities can be obtained when using the polyester urethane(meth)acrylates of the general formulae (A) and (B).

The comparison between Example 4 and Comparative Example 3' reveals that when the saturated polyester is contained in an amount of 30 parts by weight or below per 100 parts by weight of the acrylate, a high recording density is obtained and the sheet can be suitably used in the n-fold variable mode. Moreover, the results of Example 1 demonstrate that when the reactive monomer or oligomer is contained in the dye-receiving layer, a high recording density is obtained.

## Claims

1. A method of heat transfer recording which method comprises the use of a dye-receiving sheet in combination with a dye transfer sheet in either a non-variable mode in which said sheets are run at the same speed or in a variable mode in which said sheets are run at different speeds, said dye-receiving sheet comprising, on a sheet substrate, a layer comprising a cured product of a polyester urethane(meth)acrylate which has two (meth)acrylic groups and up to 30 parts by weight of a saturated polyester resin per 100 parts by weight of said polyester urethane(meth)acrylate.

2. A method according to claim 1, wherein the polyester urethane(meth)acrylate of the dye-receiving sheet has the following formula (A) 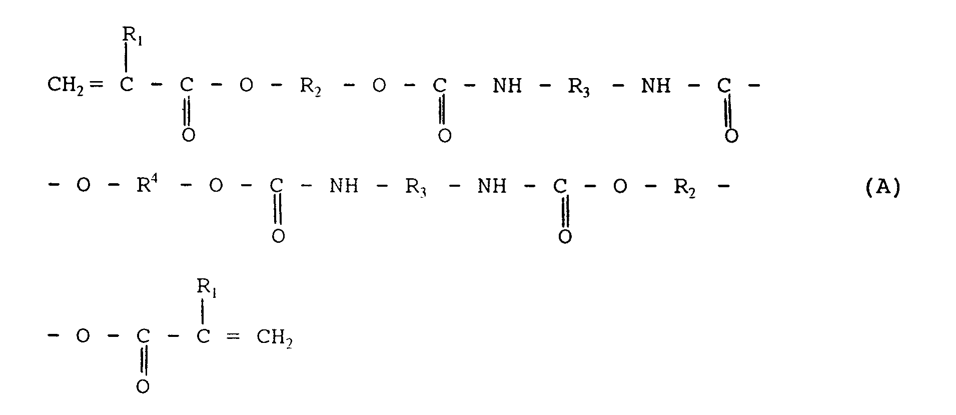 in which each R₁ represents H or CH₃, each R₂ represents a residue of a dihydric alcohol, each R₃ represents a residue of an organic diisocyanate, and R₄ represents a polyester residue having hydroxyl groups at opposite ends thereof.

3. A method according to claim 2, wherein the polyester residue represented by R₄ has a number average molecular weight not larger than 3000.

4. A method according to claim 3, wherein the polyester residue is a residue of a polyester obtained from a dihydric alcohol having from 2 to 6 carbon atoms and at least one dibasic carboxylic acid selected from adipic acid and terephthalic acid.

5. A method according to Claim 4, wherein the dihydric alcohol is ethylene glycol and/or propylene glycol.

6. A method according to claim 1, wherein the polyester urethane(meth)acrylate of the dye-receiving sheet is an acrylate of the following formula 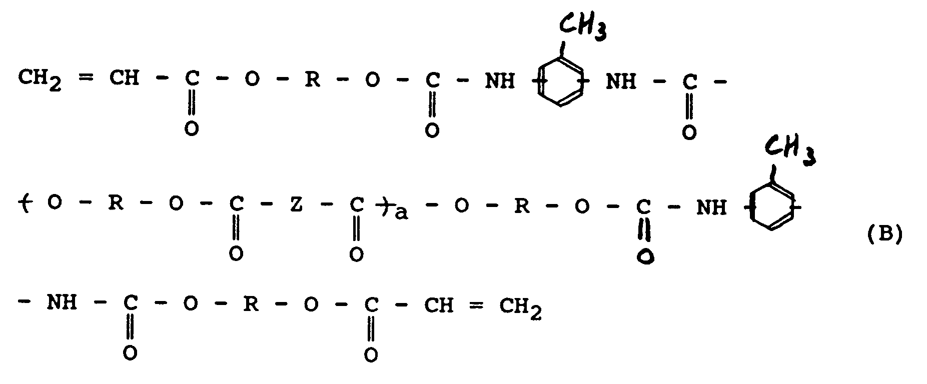 in which a is a natural number, each R represents an alkylene group and Z represents a phenylene group, a substituted phenylene group or an alkylene group.

7. A method according to any one of the preceding claims, wherein the layer of the dye-receiving sheet further comprises at least one reactive monomer or oligomer.

8. A method according to claim 1, wherein the layer of the dye-receiving sheet consists of the cured product of the (meth)acrylate.

9. A method according to any one of the preceding claims, wherein the polyester urethane(meth)acrylate of the dye-receiving sheet is thermally cured.

10. A method according to any one of claims 1 to 8, wherein the polyester urethane(meth)acrylate of the dye-receiving sheet is cured by UV irradiation and heat.

## Patentansprüche

1. Verfahren zur Übertragungsaufzeichnung durch Wärme, wobei das Verfahren die Verwendung eines Farbstoff-Aufnahmeblattes in Kombination mit einem Farbstoff-Übertragungsblatt in entweder nicht-veränderlicher Weise, bei der diese Blätter mit derselben Geschwindigkeit laufen, oder in veränderlicher Weise, bei der diese Blätter mit unterschiedlicher Geschwindigkeit laufen, umfaßt und wobei dieses Farbstoff-Aufnahmeblatt auf einem Blatträger eine Schicht umfaßt, welche ein gehärtetes Produkt eines Polyesterurethan(meth)acrylates, das zwei (Meth)Acrylgruppen besitzt, und bis zu 30 Gew.-Teile eines gesättigten Polyesterharzes pro 100 Gew.-Teile dieses Polyesterurethan(meth)acrylates umfaßt.

2. Verfahren nach Anspruch 1, worin das Polyesterurethan(meth)acrylat des Farbstoff-Aufnahmeblattes die folgende Formel (A) besitzt: 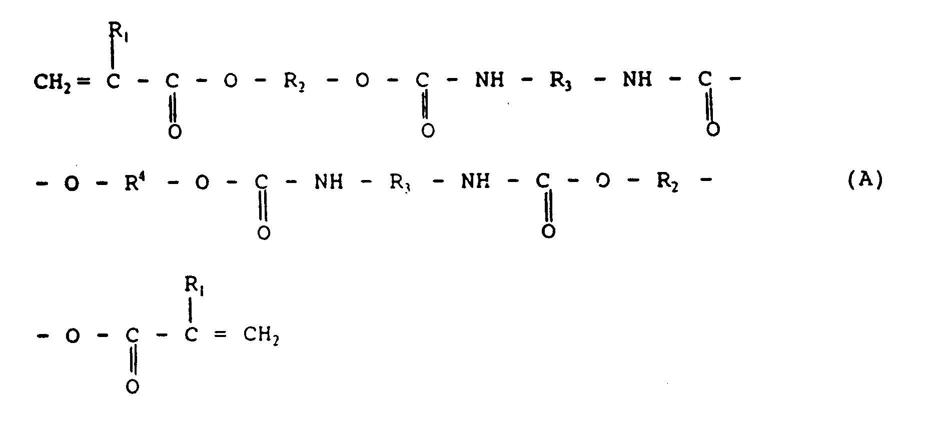 worin jedes R₁ H oder CH₃ darstellt, jedes R₂ einen Rest eines zweiwertigen Alkohols darstellt, jedes R₃ einen Rest eines organischen Diisocyanates darstellt, und R₄ einen Polyesterrest darstellt, der Hydroxylgruppen an gegenüberliegenden Enden hiervon aufweist.

3. Verfahren nach Anspruch 2, worin der durch R₄ dargestellte Polyesterrest ein Zahlendurchschnittsmolekulargewicht von nicht größer als 3000 besitzt.

4. Verfahren nach Anspruch 3, worin der Polyesterrest ein Rest eines Polyesters ist, der aus einem zweiwertigen Alkohol mit 2 bis 6 Kohlenstoffatomen und wenigstens einer zweibasigen Carbonsäure, ausgewählt aus Adipinsäure und Terephthalsäure, erhalten worden ist.

5. Verfahren nach Anspruch 4, worin der zweiwertige Alkohol Ethylenglykol und/oder Propylenglykol ist.

6. Verfahren nach Anspruch 1, worin das Polyesterurethan(meth)acrylat des Farbstoff-Aufnahmeblattes ein Acrylat der folgenden Formel ist: 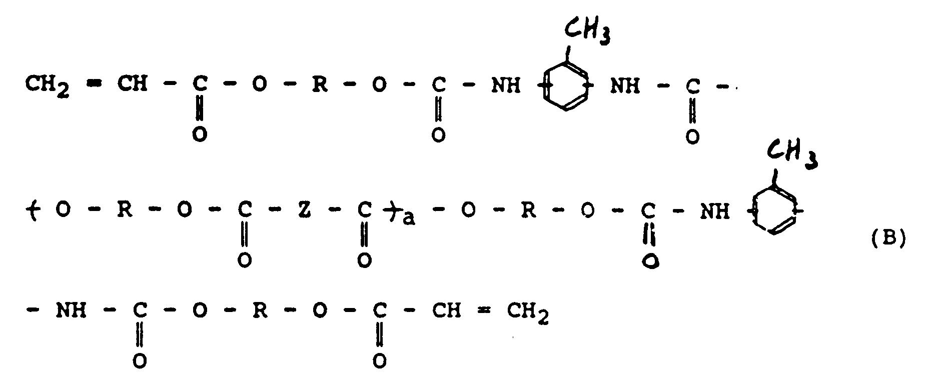 worin a eine natürliche Zahl ist, jedes R eine Alkylengruppe darstellt und Z eine Phenylengruppe, eine substituierte Phenylengruppe oder eine Alkylengruppe darstellt.

7. Verfahren nach einem der vorhergehenden Ansprüche, worin die Schicht des Farbstoff-Aufnahmeblattes weiterhin wenigstens ein reaktives Monomeres oder Oligomeres umfaßt.

8. Verfahren nach Anspruch 1, worin die Schicht des Farbstoff-Aufnahmeblattes aus dem gehärteten Produkt des (Meth)Acrylates besteht.

9. Verfahren nach einem der vorhergehenden Ansprüche, worin das Polyesterurethan(meth)acrylat des Farbstoff-Aufnahmeblattes thermisch gehärtet ist.

10. Verfahren nach einem der Ansprüche 1 bis 8, worin das Polyesterurethan(meth)acrylat des Farbstoff-Aufnahmeblattes durch UV-Bestrahlung und Wärme gehärtet ist.

## Revendications

1. Procédé d'enregistrement par transfert thermique, qui comprend l'utilisation d'une feuille réceptrice de colorant en combinaison avec une feuille de transfert de colorant, soit dans un mode non variable dans lequel on fait passer lesdites feuilles à la même vitesse, soit dans un mode variable dans lequel on fait passer lesdites feuilles à des vitesses différentes, ladite feuille réceptrice de colorant comprenant, sur un support en forme de feuille, une couche renfermant un produit résultant du durcissement d'un acrylate ou méthacrylate de polyester-uréthane, qui possède deux groupes acrylique ou méthacrylique et contient jusqu'à trente parties en poids d'une résine de polyester saturée pour cent parties en poids dudit acrylate ou méthacrylate de polyester-uréthane.

2. Procédé selon la revendication 1, dans lequel l'acrylate ou méthacrylate de polyester-uréthane de la feuille réceptrice de colorant présente la formule suivante (A) : 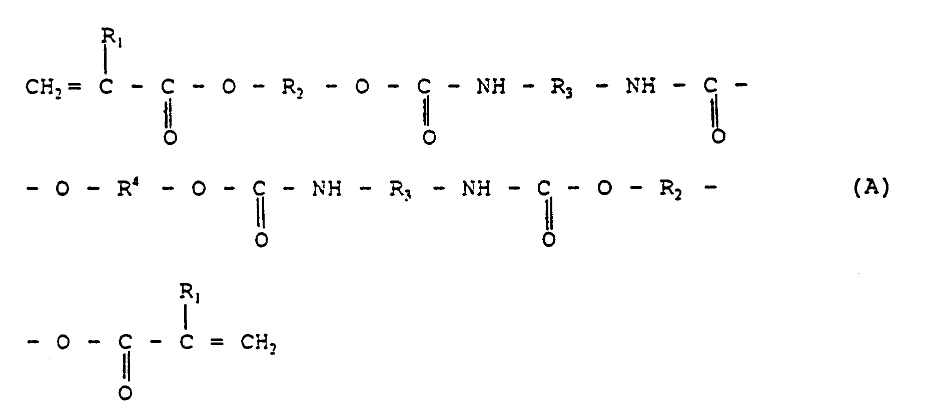 dans laquelle chaque R₁ représente un atome d'hydrogène ou un groupe CH₃, chaque R₂ représente un reste d'un alcool dihydroxylé, chaque R₃ représente un reste d'un diisocyanate organique et R₄ représente un reste de polyester ayant des groupes hydroxyles à ses extrémités opposées.

3. Procédé selon la revendication 2, dans lequel le reste de polyester représenté par R₄ présente une masse moléculaire moyenne en nombre ne dépassant pas 3000.

4. Procédé selon la revendication 3, dans lequel le reste d'un polyester est un reste d'un polyester obtenu à partir d'un alcool dihydroxylé ayant deux à six atomes de carbone et d'au moins un acide dicarboxylique choisi parmi l'acide adipique et l'acide téréphtalique.

5. Procédé selon la revendication 4, dans lequel l'alcool dihydroxylé est l'éthylèneglycol et/ou le propylèneglycol.

6. Procédé selon la revendication 1, dans lequel l'acrylate ou méthacrylate de polyester-uréthane de la feuille réceptrice de colorant est un acrylate répondant à la formule suivante : 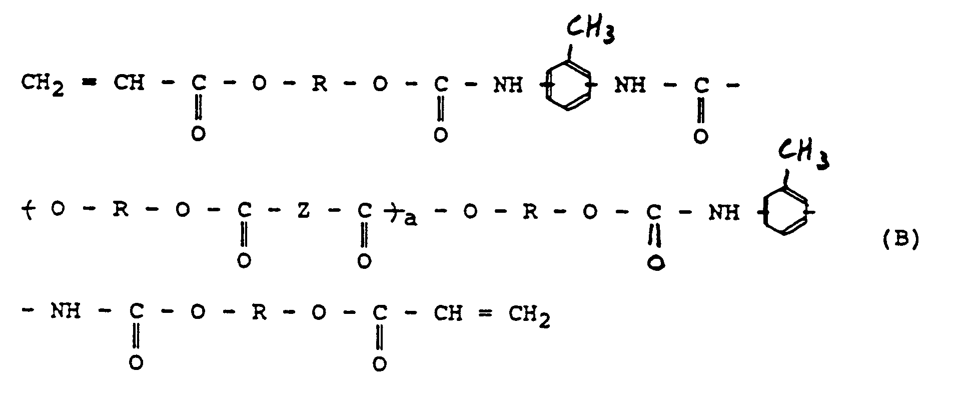 dans laquelle a est un nombre entier naturel, chaque R représente un groupe alkylène et Z représente un groupe phénylène, un groupe phénylène substitué ou un groupe alkylène.

7. Procédé selon l'une quelconque des revendications précédentes, dans lequel la couche de la feuille réceptrice de colorant comprend en outre au moins un monomère ou oligomère réactif.

8. Procédé selon la revendication 1, dans lequel la couche de la feuille réceptrice de colorant est constituée du produit résultant du durcissement de l'acrylate ou du méthacrylate.

9. Procédé selon l'une quelconque des revendications précédentes, dans lequel l'acrylate ou méthacrylate de polyester-uréthane de la feuille réceptrice de colorant est durci par un procédé thermique.

10. Procédé selon l'une quelconque des revendications 1 à 8, dans lequel l'acrylate ou méthacrylate de polyester-uréthane de la feuille réceptrice de colorant est durci par exposition aux rayons UV et action de la chaleur.
